# EUROPÄISCHE PATENTSCHRIFT

(11) **EP 2 820 674 B1**
(45) Veröffentlichungstag und Bekanntmachung des Hinweises auf die Patenterteilung: **26.08.2020**
(21) Anmeldenummer: 13701030.2
(22) Anmeldetag: 18.01.2013
(51) Int. Cl.: H01L 23/66, H01L 23/00, H01Q 23/00

(54) **HALBLEITERMODUL MIT INTEGRIERTEN ANTENNENSTRUKTUREN**
SEMICONDUCTOR MODULE HAVING INTEGRATED ANTENNA STRUCTURES
MODULE À SEMI-CONDUCTEUR COMPRENANT DES STRUCTURES D'ANTENNE INTÉGRÉES

(30) Priorität: 29.02.2012 DE 102012203151
(43) Veröffentlichungstag der Anmeldung: 07.01.2015
(73) Patentinhaber: Robert Bosch GmbH, 70442 Stuttgart (DE)
(72) Erfinder: MITTELSTRASS, Delf, 71292 Friolzheim (DE); BINZER, Thomas, 74379 Ingersheim (DE)
(86) Internationale Anmeldenummer: PCT/EP2013/050930
(87) Internationale Veröffentlichungsnummer: WO 2013/127562

(56) Entgegenhaltungen:
- DE-A1-102006 023 123
- DE-A1-102010 001 407
- US-A1- 2010 133 349

## Beschreibung

Die Erfindung betrifft ein Halbleitermodul mit einer integrierten Schaltung, die wenigstens einen Oszillator zur Erzeugung eines Radarsignals umfasst, und mit einer Umverdrahtungsschicht zum externen Anschließen der integrierten Schaltung sowie mit wenigstens zwei im Halbleitermodul integrierten Antennenstrukturen zum Senden und/oder Empfangen von Radarsignalen, wobei von den wenigstens zwei Antennenstrukturen wenigstens eine mit der integrierten Schaltung verbunden ist. Insbesondere betrifft die Erfindung ein derartiges Halbleitermodul für Kraftfahrzeug-Radaranwendungen. Weiter betrifft die Erfindung einen Radarsensor mit einem solchen Halbleitermodul sowie ein Kraftfahrzeug-Radarsystem mit einem Halbleitermodul dieser Art.

### STAND DER TECHNIK

Radarsensoren werden zur Abstands- und/oder Geschwindigkeitsmessung von Objekten verwendet. Insbesondere sind Radarsysteme bekannt, bei denen Geschwindigkeiten und Distanzen mehrerer Objekte simultan erfasst werden. Es sind beispielsweise Fahrgeschwindigkeitsregler für Kraftfahrzeuge mit einem Radarsystem zur Ortung eines vorausfahrenden Fahrzeuges und zur Messung des Abstandes zu diesem bekannt. Ein solches Abstandsregelsystem wird auch als ACC-System (Adaptive Cruise Control) bezeichnet.

Zur Vereinfachung des Aufbaus von HF-Schaltungen für Radaranwendungen werden für die Sende- und Empfangsschaltungen zunehmend integrierte Mikrowellenschaltungen des MMIC-Typs verwendet (Microwave Monolithic Integrated Circuit).

Es sind Wafer-Baugruppen bekannt, bei denen die Baugruppe mit einer Umverdrahtungsschicht für ein IC-Bauelement auf Wafer-Ebene hergestellt wird. Eine solche Wafer-Baugruppe wird auch als eingebettetes Gitter-Array auf Waferebene (eWLB, embedded Wafer Level Ball Grid Array) bezeichnet.

DE 10 2010 001 407 A1 beschreibt ein Halbleitermodul, bei dem auf Wafer-Ebene Antennen integriert sind. Das Halbleitermodul umfasst eine erste Gehäusemoldmassenschicht und ein IC-Bauelement mit einem integrierten Schaltkreis, das in die erste Gehäusemoldmassenschicht eingebettet ist. Eine Zwischenschicht umfasst eine Umverdrahtungsschicht, welche an das IC-Bauelement angeschlossen ist und dazu dient, das IC-Bauelement extern anzuschließen. Eine integrierte Antennenstruktur ist innerhalb der Zwischenschicht angeordnet und ist an das IC-Bauelement angeschlossen. Ein derartiges Halbleitermodul kann mit für den Hochfrequenzbereich von beispielsweise 77 GHz geeigneter Präzision konfektioniert werden. Ein solches eWLB-Halbleitermodul mit im Gehäuse integrierten Antennen wird auch als Antenna in Package (AiP) bezeichnet. In einem Beispiel ist die integrierte Antennenstruktur eine Patchantenne, und auf der Oberfläche des Halbleitermoduls ist ein zusätzliche zweite Antennenstruktur in Form einer parasitären Mikrostreifen-Patchantenne angeordnet, die bei einer geringfügig geringeren Frequenz schwingt und deshalb die Impedanzbreite der integrierten Antennenstrukturen erhöhen kann.

US 2010/0133349 A1 beschreibt ein Halbleitergehäuse mit einem Halbleiterchip, einer als Antenne dienenden Kontaktfläche, wobei der zwischen dem Halbleiterchip und der Kontaktfläche ein Dielektrikum angeordnet ist, und mit einer Gehäusemasse, die den Halbleiterchip und die Kontaktfläche einschließt. Auf einer mit der Kontaktfläche verbundenen Leitung ist ein RFID-Kommunikationselement in Form eines zweiten Halbleiterchips angeordnet, der drahtlos mit einem externen Gerät kommuniziert. Der erste Halbleiterchip erzeugt und verstärkt ein Signal, um Hochfrequenzwellen zu erzeugen, die von der Kontaktfläche und der Leitung auf das Kommunikationselement übertragen und von dem Kommunikationselement nach außen gesendet werden.

DE 10 2006 023 123 A1 beschreibt ein Halbleitermodul mit Komponenten für Höchstfrequenztechnik.

### OFFENBARUNG DER ERFINDUNG

Bei einem eWLB-Halbleitermodul mit integrierter Schaltung und integrierten Antennenstrukturen ergibt sich durch die in einer Ebene angeordnete integrierte Antennenstruktur eine schmale Bandbreite. Für Kraftfahrzeug-Radaranwendungen, insbesondere für FMCW-Radarsysteme (Frequency Modulated Continuous Wave), sind jedoch breitbandige Antennenstrukturen wünschenswert.

Aufgabe der Erfindung ist es, ein neuartiges Halbleitermodul für Radaranwendungen zu schaffen, welches es ermöglicht, eine Antenne mit verbesserter Bandbreite zur Verfügung zu stellen.

Diese Aufgabe wird erfindungsgemäß durch ein Halbleitermodul nach Anspruch 1 gelöst, bei dem wenigstens eine erste der Antennenstrukturen auf einer anderen Höhe angeordnet ist als wenigstens eine zweite der Antennenstrukturen, und bei dem die wenigstens eine erste Antennenstruktur außerhalb eines Höhenbereichs der Umverdrahtungsschicht in ein Gehäusematerial des Halbleitermoduls eingebettet ist.

In der vorliegenden Beschreibungen gehören nur solche Ausführungsbeispiele zur Erfindung, welche alle Merkmale eines der Ansprüche 1 oder 9 aufweisen.

Das Gehäusematerial ist vorzugsweise eine Gehäusemoldmasse, d.h. ein Formmaterial oder Vergussmaterial, welches das Gehäuse für die integrierte Schaltung bildet.

Indem eine oder mehrere erste Antennenstrukturen in das Gehäusematerial des Halbleitermoduls eingebettet sind, können Positionen und insbesondere ein Höhenabstand der Antennenstrukturen frei vorgegeben werden. Außerdem wird es so ermöglicht, Antennenstrukturen auf mehr als zwei unterschiedlichen Höhen übereinander gestapelt anzuordnen, so dass sich verbesserte Möglichkeiten zur Festlegung der Bandbreite und gegebenenfalls der Richtcharakteristik einer von den Antennenstrukturen gebildeten Antenne ergeben. Das Gehäusematerial kann beispielsweise bei der Herstellung des Halbleitermoduls in zwei oder mehr Teilschichten aufgebracht werden, zwischen denen eine Antennenstruktur beispielsweise in einer Metallisierungslage angebracht werden kann.

Der Oszillator ist insbesondere ein Oszillator zur Erzeugung eines Radarsignals mit Frequenzen im Bereich von Mikrowellen, also Dezimeter-, Zentimeter- und/oder Millimeterwellen.

Bevorzugt weist das Halbleitermodul eine Wafereinheit und eine Schnittstellenschicht auf, wobei die Wafereinheit einen Halbleiterchip, der die integrierte Schaltung bildet, und eine Gehäuseschicht aufweist, die durch das Gehäusematerial des Halbleitermoduls gebildet wird, und in die der Halbleiterchip sowie die wenigstens eine erste Antennenstruktur eingebettet sind, und wobei die Schnittstellenschicht die Umverdrahtungsschicht aufweist, welche die integrierte Schaltung an externe Anschlüsse der Schnittstellenschicht anschließt. Insbesondere ist das Halbleitermodul bevorzugt ein eWLB-Package.

Vorzugsweise ist die wenigstens eine zweite Antennenstruktur innerhalb des Höhenbereichs der Umverdrahtungsschicht angeordnet. Besonders bevorzugt ist die wenigstens eine zweite Antennenstruktur in der genannten Schnittstellenschicht angeordnet. Beispielsweise kann die zweite Antennenstruktur in einem Verfahrensschritt gemeinsam mit der Umverdrahtungsschicht hergestellt werden. Die wenigstens zweite Antennenstruktur ist beispielsweise in der Umverdrahtungsschicht angeordnet. Beispielsweise kann die wenigstens eine zweite Antennenstruktur über die Umverdrahtungsschicht mit der integrierten Schaltung verbunden sein.

Die Antennenstrukturen sind gestapelte Antennenstrukturen, d.h. sie sind mit Höhenversatz übereinander angeordnet. Dies ermöglicht in besonders vorteilhafter Weise die Einstellung der Antenneneigenschaften.

Die Antennenstrukturen sind seitlich gegenüber dem genannten Halbleiterchip versetzt. Insbesondere ist die wenigstens eine erste Antennenstruktur seitlich gegenüber dem Halbleiterchip versetzt gegenüber in einem Bereich seitlich neben dem Halbleiterchip in der Gehäuseschicht angeordnet. Es können beispielsweise mehrere Antennenstrukturen seitlich gegenüber dem Halbleiterchip versetzt auf unterschiedlichen Höhen in einem Bereich neben dem Halbleiterchip in der Gehäuseschicht angeordnet sein. Beispielsweise kann wenigstens eine zweite Antennenstruktur seitlich gegenüber dem Halbleiterchip versetzt in einem Bereich außerhalb des Halbleiterchips in der Schnittstellenschicht angeordnet sein. Die Wafereinheit und die Schnittstellenschicht verlaufen beispielsweise parallel, wobei sich die Schnittstellenschicht über einen Bereich des Halbleiterchips und über einen außerhalb dieses Bereichs gelegenen Bereichs erstreckt.

Die Aufgabe wird weiter gelöst durch ein Verfahren nach Anspruch 9. Dies ist ein Verfahren zur Herstellung eines Halbleitermoduls mit integrierten Antennenstrukturen für Radarsignale, mit den Schritten:
- Bereitstellen eines Halbleiterchips in Form einer integrierten Schaltung, die wenigstens einen HF-Oszillator umfasst; und
- Herstellen einer an den Halbleiterchip zumindest seitlich angrenzenden Gehäuseschicht eines Gehäuses des Halbleitermoduls, wobei das Herstellen der Gehäuseschicht die Schritte umfasst: Herstellen einer Teilschicht der Gehäuseschicht, Herstellen wenigstens einer ersten Antennenstruktur auf der Teilschicht, und Herstellen einer weiteren, die erste Antennenstruktur bedeckenden Teilschicht der Gehäuseschicht;
wobei das Verfahren weiter die Schritte umfasst:
- Herstellen wenigstens einer zweiten, in das Halbleitermodul integrierten Antennenstruktur; und
- Herstellen einer Umverdrahtungsschicht zumindest auf einer Oberfläche der Gehäuseschicht, und
wobei in dem Schritt des Herstellens wenigstens einer ersten Antennenstruktur die wenigstens eine erste Antennenstruktur außerhalb eines Höhenbereichs der Umverdrahtungsschicht hergestellt wird,
wobei die wenigstens eine erste Antennenstruktur auf einer anderen Höhenebene als die wenigstens eine zweite Antennenstruktur hergestellt wird,
wobei die wenigstens zwei Antennenstrukturen gestapelte Antennenstrukturen sind, und
wobei die wenigstens eine erste Antennenstruktur seitlich gegenüber einem die integrierte Schaltung bildenden Halbleiterchip versetzt in einem Bereich seitlich neben dem Halbleiterchip in das genannte Gehäusematerial des Halbleitermoduls eingebettet ist.

### KURZE BESCHREIBUNG DER ZEICHNUNGEN

Bevorzugte Ausführungsbeispiele der Erfindung werden im folgenden anhand der Zeichnungen näher erläutert.

Es zeigen:
- Fig. 1: eine schematische Querschnittsansicht eines Halbleitermoduls mit zwei integrierten Antennenstrukturen;
- Fig. 2: eine schematische Querschnittsansicht eines Halbleitermoduls mit drei integrierten Antennenstrukturen;
- Fig.3: eine schematische Querschnittsansicht eines Halbleitermoduls mit vier integrierten Antennenstrukturen; und
- Fig. 4: ein Flussdiagramm, das ein Verfahren zur Herstellung eines Halbleitermoduls veranschaulicht.

### BESCHREIBUNG VON AUSFÜHRUNGSBEISPIELEN

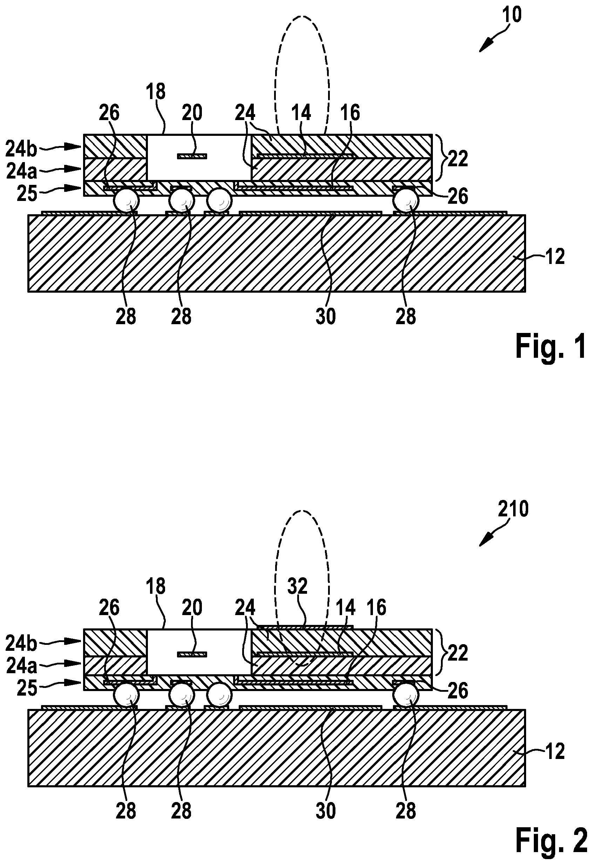

Fig. 1 zeigt schematisch in einer Querschnittsansicht ein Halbleitermodul 10, das auf einer Leiterplatte 12 angebracht ist.

Das Halbleitermodul 10 umfasst eine erste integrierte Antennenstruktur 14, eine zweite integrierte Antennenstruktur 16 und eine integrierte Schaltung 18 in Form eines Halbleiterchips. Die integrierte Schaltung 18 umfasst den HF-Teil einer Sende- und Empfangsschaltung für Radarsignale und ist mit der zweiten Antennenstruktur 16 verbunden. Insbesondere enthält die integrierte Schaltung 18 einen HF-Oszillator 20 zur Erzeugung eines Radarsignals zur Abstrahlung durch die Antennenelemente 14, 16. Weiter umfasst die integrierte Schaltung 18 in an sich bekannter Weise einen Mischer zum Mischen eines über die Antennenstrukturen 14, 16 emfangenen Radarsignals mit dem gesendeten Signal. Bei der integrierten Schaltung 18 handelt es sich um einen sogenannten MMIC-Chip (Monolithic Microwave Integrated Circuit).

Bei dem Halbleitermodul 10 handelt es sich um ein sogenanntes eWLB-Package, bei dem eine Wafereinheit 22 den die integrierte Schaltung 18 bildenden Halbleiterchip und eine Gehäusemoldmassenschicht in Form einer Gehäuseschicht 24 umfasst, in die der Halbleiterchip eingebettet ist. Diese während der Herstellung zusammengesetzte Wafereinheit 22 wird auch als Reconstituted Wafer bezeichnet. Die Wafereinheit 22 ist mit einer Schnittstellenschicht 25 versehen, die eine Umverdrahtungsschicht 26 und Anschlüsse 28 in Form von 3D-Verbindungsstrukturen, insbesondere Lotkugeln, aufweist. Die Umverdrahtungsschicht 26 hat auf einer ersten Seite Kontaktstellen, die Kontaktstellen der Wafereinheit 22 kontaktieren. Auf einer zweiten Seite ist die Umverdrahtungsschicht 26 mit den Anschlüssen 28 zur externen Kontaktierung verbunden. Auf diese Weise ist die integrierte Schaltung 18 an die Anschlüsse 28 der Schnittstellenschicht 25 angeschlossen. Fig. 1 zeigt exemplarisch vier Anschlüsse 28, die an Leiterbahnen dreier Leiterplatten 12 angeschlossen sind. Das Halbleitermodul 10 kann mittels Standardprozessen, insbesondere Oberflächenmontage-Prozessen auf die Leiterplatte 12 aufgebracht werden.

In die Schnittstellenschicht 25 ist im Höhenbereich der Umverdrahtungsschicht 26 die zweite Antennenstruktur 16 integriert und in der Schnittstellenschicht mit der integrierten Schaltung 18 verbunden. Insbesondere sind die zweite Antennenstruktur 16 und die Verbindung zur integrierten Schaltung 18 als Teil der Umverdrahtungsschicht 26 in die Schnittstellenschicht 25 integriert.

Die zweite Antennenstruktur 16 ist seitlich gegenüber dem Halbleiterchip versetzt und liegt somit im Bereich neben der Gehäuseschicht 24, außerhalb eines dem Halbleiterchip benachbarten Bereichs der Schnittstellenschicht 24.

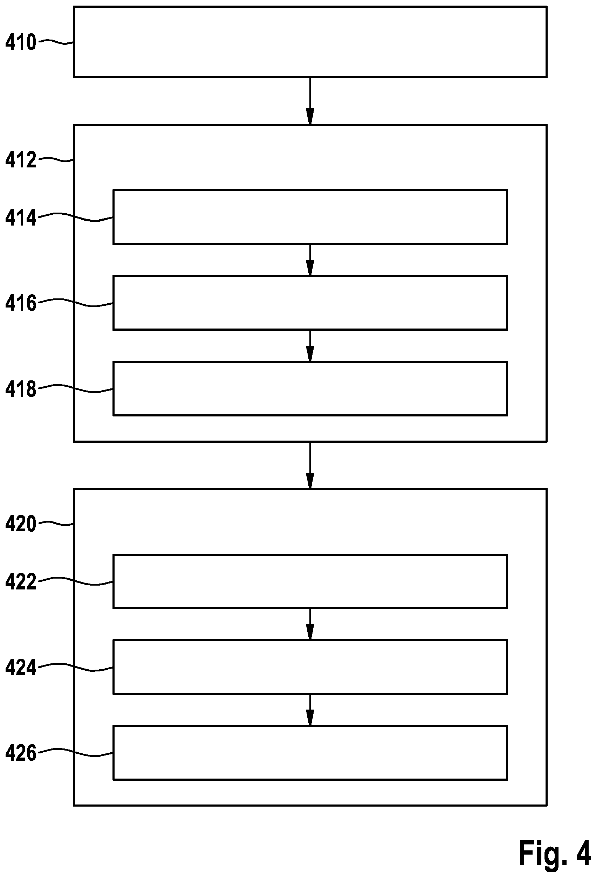

In Höhenrichtung beabstandet von der zweiten Antennenstruktur 16 ist die erste Antennenstruktur 14 seitlich neben dem Halbleiterchip in der Gehäuseschicht 24 eingebettet. Die ersten und zweiten Antennenstrukturen 14, 16 bilden somit eine gestapelte Antennenanordnung. Weiter unten wird anhand von Fig. 4 beispielhaft ein Verfahren zur Herstellung des Halbleitermoduls beschrieben.

Im beschriebenen Beispiel ist die ersten Antennenstruktur 14 nicht elektrisch angeschlossen, sondern sie wird über elektromagnetische Kopplung angeregt. Die erste Antennenstruktur 14 kann aber auch mit der integrierten Schaltung 18 verbunden sein, etwa über wenigstens eine Durchkontaktierung (Via) in einer Teilschicht der Gehäuseschicht 24.

Beispielsweise weisen die ersten und zweiten Antennenstrukturen 14, 16 leicht unterschiedliche Resonanzeigenschaften auf, insbesondere unterschiedliche Resonanzfrequenzbereiche. Dies kann beispielsweise durch unterschiedliche Abmessungen der ersten und zweiten Antennenstrukturen 14, 16 erreicht werden. Die Breitbandigkeit des Resonanzbereichs der aus den Antennenstrukturen 14, 16 gebildeten Antenne wird dadurch gegenüber der einzelnen Antennenstruktur 16 vergrößert.

In Fig. 1 ist gestrichelt eine Hauptabstrahlrichtung der aus den Antennenstrukturen 14, 16 gebildeten Antenne senkrecht zur Wafereinheit 22 dargestellt.

Die Antennenstrukturen 14, 16 können beispielsweise Patchantennenelemente umfassen. Die Antennenstrukturen 14, 16 können aber auch andere Antennenelemente umfassen, beispielsweise gedruckte Dipolantennenelemente, insbesondere elektrische oder magnetische Dipole. Die Antennenstrukturen 14, 16 erstrecken sich beispielsweise jeweils in einer einzigen Ebene.

Auf einer der Hauptabstrahlrichtung gegenüberliegenden Seite ist im gezeigten Beispiel die Leiterplatte 12 optional mit einem Reflektor 30 in Form eines leitfähigen Bereichs versehen.

Durch die Integration der Antennenstrukturen 14, 16 in das auf Waferebene gefertigte Halbleitermodul mit Antenne im Gehäuse (Antenna in Package, AiP) ist eine präzise Anbindung der mit der integrierten Schaltung 18 verbundenen Antennenstruktur 16 und eine präzise Ausrichtung der Antennenstrukturen 14, 16 zueinander möglich. Es wird eine besonders effiziente Herstellung ermöglicht. Im beschriebenen Bespiel kann durch die als parasitäre Antennenstruktur betriebene erste Antennenstruktur 14 in präzise definierbarer Weise die Charakteristik der Resonanzbandbreite eingestellt werden.

Im gezeigten Beispiel können die ersten und zweiten Antennenstrukturen 14, 16 zum Senden und Empfangen eines Radarsignals dienen. Es ist aber beispielsweise auch denkbar, mehrere zweite Antennenstrukturen 16 und/oder mehrere erste Antennenstrukturen 14 vorzusehen. Insbesondere können mehrere zweite Antennenstrukturen 16 nebeneinander auf derselben Ebene vorgesehen sein, und es können mehrere erste Antennenstrukturen 14 nebeneinander auf einer selben Ebene vorgesehen sein, wobei getrennte Antennenstrukturen zum Senden und zum Empfangen vorgesehen sein können.

Fig. 2 zeigt ein weiteres Beispiel eines Halbleitermoduls 210, das sich von dem beschriebenen Halbleitermodul 10 der Fig. 1 dadurch unterscheidet, dass auf einer Oberfläche der Wafereinheit 22 eine dritte Antennenstruktur 32 aufgebracht ist. Übereinstimmende Komponenten der Halbleitermodule 10 und 210 sind mit denselben Bezugszeichen gekennzeichnet.

Im gezeigten Beispiel ist die dritte Antennenstruktur 32 nicht elektrisch verbunden. Sie wird vielmehr, wie die erste Antennenstruktur 14, über eine elektromagnetische Kopplung durch die ersten und zweiten Antennenstrukturen 14, 16 angeregt. Beispielsweise unterscheiden sich die Resonanzeigenschaften der Antennenstrukturen 14, 16, 32 jeweils voneinander, so dass die ersten und dritten Antennenstrukturen, 14, 32 die Breitbandigkeit der von den Antennenstrukturen gebildeten Antenne erhöhen.

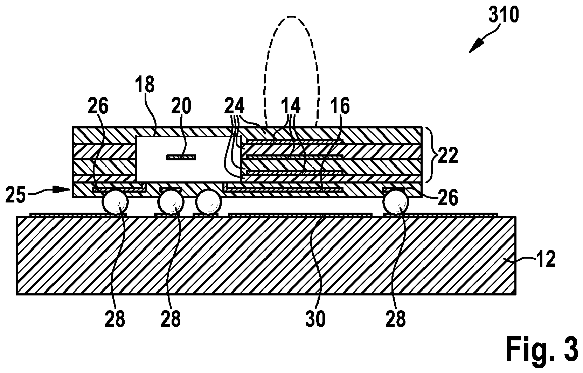

Fig. 3 zeigt ein weiteres Ausführungsbeispiel eines Halbleitermoduls 310, das sich von dem Halbleitermodul 10 gemäß Fig. 1 dadurch unterscheidet, dass mehrere erste Antennenstrukturen 14 auf unterschiedlichen Höhen außerhalb eines Höhenbereichs der Umverdrahtungsschicht in die Gehäusemoldmasse des Halbleitermoduls eingebettet sind. Die übrigen Merkmale und Komponenten stimmen beispielsweise mit dem Beispiel nach Fig. 1 überein und sind mit denselben Bezugszeichen gekennzeichnet.

Im Beispiel der Fig. 3 erstreckt sich die Gehäuseschicht 24 über eine der Umverdrahtungsschicht 26 entgegengesetzte Seite der integrierten Schaltung 18. Die integrierte Schaltung 18 ist somit allseitig von der Schnittstellenschicht 25 und der Gehäuseschicht 24 umgeben.

Im folgenden wird anhand von Fig. 4 ein Herstellungsverfahren für ein oben beschriebenes Halbleitermodul am Beispiel einer Herstellung des Halbleitermoduls 10 beschrieben.

In einem ersten Schritt 410 wird die integrierte Schaltung 18 in Form eines Halbleiterchips mit dem integrierten HF-Oszillator 20 zur Verfügung gestellt.

In einem Schritt 412 wird die an den Halbleiterchip zumindest seitlich angrenzende Gehäuseschicht 24 des Gehäuses des Halbleitermoduls 10 hergestellt. Der Schritt des Herstellens der Gehäuseschicht 24 umfasst einen Schritt 414 des Herstellens wenigstens einer ersten Teilschicht 24a (Fig. 1) der Gehäuseschicht 24, einen Schritt 416 des Herstellens wenigstens einer ersten Antennenstruktur 14 in einer Metallisierungsschicht auf der Teilschicht 24a, und einen Schritt 418 des Herstellens einer weiteren, die erste Antennenstruktur 14 bedeckenden Teilschicht 24b der Gehäuseschicht 24. Zur Herstellung mehrerer ersten Antennenstrukturen 14 auf unterschiedlichen Höhen innerhalb der Gehäuseschicht 24 können die Schritte 416 und 418 wiederholt ausgeführt werden, beispielsweise zur Herstellung des Halbleitermoduls 310 nach Fig. 3.

Das Verfahren umfasst weiter den Schritt 420 des Herstellens einer Schnittstellenschicht 25 mit dem Schritt 422 des Herstellens einer Umverdrahtungsschicht 26, den Schritt 424 des Herstellens der zweiten Antennenstruktur 16 als Teil der Schnittstellenschicht 25, und optional einen Schritt 426 des Herstellens einer Anschlussstruktur mit externen Anschlüssen 28, die beispielsweise über die Umverdrahtungsschicht 26 mit der integrierten Schaltung 18 verbunden werden.

Der Schritt 424 des Herstellens einer zweiten Antennenstruktur 16 kann abweichend von den beschriebenen Beispielen auch innerhalb des Schrittes 412 des Herstellens der Gehäuseschicht erfolgen. Das heißt, die zweite Antennenstruktur 16 ist optional ebenfalls außerhalb des Höhenbereichs der Schnittstellenschicht 25 angeordnet. Die zweite Antennenstruktur 16 wird stets auf einer anderen Höhenebene als die erste Antennenstruktur 14 angeordnet. Sie kann beispielsweise auch auf einer Oberfläche der Gehäuseschicht 14 aufgebracht werden entsprechend der Antennenstruktur 32 nach dem Beispiel der Fig. 2.

## Patentansprüche

1. Halbleitermodul, aufweisend:
- eine integrierte Schaltung (18), die wenigstens einen HF-Oszillator (20) zur Erzeugung eines Radarsignals umfasst;
- eine Umverdrahtungsschicht (26) zum externen Anschließen der integrierten Schaltung (18); und
- wenigstens zwei im Halbleitermodul (10) integrierte Antennenstrukturen (14; 16) zum Senden und/oder Empfangen von Radarsignalen, wobei von den wenigstens zwei Antennenstrukturen (14; 16) wenigstens eine mit der integrierten Schaltung (18) verbunden ist, und
wobei wenigstens eine erste der Antennenstrukturen (14) auf einer anderen Höhe angeordnet ist als wenigstens eine zweite der Antennenstrukturen (16),
wobei die wenigstens zwei Antennenstrukturen (14; 16) gestapelte Antennenstrukturen sind,
wobei die wenigstens eine erste Antennenstruktur (14) außerhalb eines Höhenbereichs der Umverdrahtungsschicht (26) in ein Gehäusematerial des Halbleitermoduls (10) eingebettet ist,
wobei die wenigstens eine erste Antennenstruktur (14) seitlich gegenüber einem die integrierte Schaltung (18) bildenden Halbleiterchip versetzt innerhalb eines Höhenbereichs des besagten Halbleiterchips in das genannte Gehäusematerial des Halbleitermoduls (10) eingebettet ist.

2. Halbleitermodul nach Anspruch 1, bei dem wenigstens eine zweite der Antennenstrukturen (16) in einem Höhenbereich der Umverdrahtungsschicht (26) angeordnet ist.

3. Halbleitermodul nach einem der vorstehenden Ansprüche, bei dem das Halbleitermodul (10) eine Wafereinheit (22) und eine Schnittstellenschicht (25) aufweist, wobei die Wafereinheit (22) einen Halbleiterchip, der die integrierte Schaltung (18) bildet und eine Gehäuseschicht (24) aufweist, die durch das genannte Gehäusematerial des Halbleitermoduls (10) gebildet wird und in die der Halbleiterchip sowie die wenigstens eine erste Antennenstruktur (14) eingebettet sind, und wobei die Schnittstellenschicht (25) die Umverdrahtungsschicht (26) aufweist, welche die integrierte Schaltung (18) mit externen Anschlüssen (28) der Schnittstellenschicht (25) verbindet.

4. Halbleitermodul nach Anspruch 3, bei dem wenigstens eine zweite der Antennenstrukturen (16) in der Schnittstellenschicht (25) angeordnet ist.

5. Halbleitermodul nach einem der vorstehenden Ansprüche, bei dem wenigstens eine zweite der Antennenstrukturen (16) mit der integrierten Schaltung (18) verbunden ist.

6. Halbleitermodul nach einem der vorstehenden Ansprüche, bei dem mehrere im Halbleitermodul integrierte Antennenstrukturen (14) seitlich gegenüber einem die integrierte Schaltung (18) bildenden Halbleiterchip versetzt innerhalb eines Höhenbereichs des besagten Halbleiterchips in das genannte Gehäusematerial des Halbleitermoduls (10) eingebettet sind.

7. Radarsensor mit einem Halbleitermodul nach einem der Ansprüche 1 bis 6.

8. Kraftfahrzeug-Radarsystem mit einem Halbleitermodul nach einem der Ansprüche 1 bis 6.

9. Verfahren zur Herstellung eines Halbleitermoduls (10) mit integrierten Antennenstrukturen (14; 16) für Radarsignale, mit den Schritten:
- Bereitstellen (410) eines Halbleiterchips in Form einer integrierten Schaltung (18), die wenigstens einen HF-Oszillator (20) zur Erzeugung eines Radarsignals umfasst; und
- Herstellen (412) einer an den Halbleiterchip zumindest seitlich angrenzenden Gehäuseschicht (24) eines Gehäuses des Halbleitermoduls (10), wobei das Herstellen der Gehäuseschicht (24) die Schritte umfasst: Herstellen (414) einer Teilschicht (24a) der Gehäuseschicht (24), Herstellen (416) wenigstens einer ersten Antennenstruktur (14) auf der Teilschicht (24a), und Herstellen (418) einer weiteren, die erste Antennenstruktur (14) bedeckenden Teilschicht (24b) der Gehäuseschicht (24);
wobei das Verfahren außerdem die Schritte umfasst:
- Herstellen (424) wenigstens einer zweiten, in das Halbleitermodul (10) integrierten Antennenstruktur (16); und
- Herstellen (422) einer Umverdrahtungsschicht (26) zumindest auf einer Oberfläche der Gehäuseschicht (24), und
wobei in dem Schritt des Herstellens (416) wenigstens einer ersten Antennenstruktur (14) die wenigstens eine erste Antennenstruktur (14) außerhalb eines Höhenbereichs der Umverdrahtungsschicht (26) hergestellt wird,
wobei die wenigstens eine erste Antennenstruktur (14) auf einer anderen Höhenebene als die wenigstens eine zweite Antennenstruktur (16) hergestellt wird,
wobei die wenigstens zwei Antennenstrukturen (14; 16) gestapelte Antennenstrukturen sind, und
wobei die wenigstens eine erste Antennenstruktur (14) seitlich gegenüber einem die integrierte Schaltung (18) bildenden Halbleiterchip versetzt innerhalb eines Höhenbereichs des besagten Halbleiterchips in das genannte Gehäusematerial des Halbleitermoduls (10) eingebettet ist.

## Claims

1. Semiconductor module having:
- an integrated circuit (18) that comprises at least one RF oscillator (20) for generating a radar signal;
- a redistribution layer (26) for externally connecting the integrated circuit (18); and
- at least two antenna structures (14; 16), integrated in the semiconductor module (10), for sending and/or receiving radar signals, wherein at least one of the at least two antenna structures (14; 16) is connected to the integrated circuit (18), and wherein at least one first of the antenna structures (14) is arranged at a different height from at least one second of the antenna structures (16),
wherein the at least two antenna structures (14; 16) are stacked antenna structures,
wherein the
at least one first antenna structure (14) is embedded in a package material of the semiconductor module (10) outside a height area of the redistribution layer (26), wherein the at least one first antenna structure (14) is embedded in said package material of the semiconductor module (10) inside a height area of a semiconductor chip forming the integrated circuit (18) in a manner laterally offset from said semiconductor chip.

2. Semiconductor module according to Claim 1, in which at least one second of the antenna structures (16) is arranged in a height area of the redistribution layer (26).

3. Semiconductor module according to either of the preceding claims, in which the semiconductor module (10) has a wafer unit (22) and an interface layer (25), wherein the wafer unit (22) has a semiconductor chip, which forms the integrated circuit (18), and a package layer (24), which is formed by said package material of the semiconductor module (10) and in which the semiconductor chip and the at least one first antenna structure (14) are embedded, and wherein the interface layer (25) has the redistribution layer (26), which connects the integrated circuit (18) to external connections (28) of the interface layer (25).

4. Semiconductor module according to Claim 3, in which at least one second of the antenna structures (16) is arranged in the interface layer (25).

5. Semiconductor module according to one of the preceding claims, in which at least one second of the antenna structures (16) is connected to the integrated circuit (18).

6. Semiconductor module according to one of the preceding claims, in which multiple antenna structures (14) integrated in the semiconductor module are embedded in said package material of the semiconductor module (10) inside a height area of a semiconductor chip forming the integrated circuit (18) in a manner laterally offset from said semiconductor chip.

7. Radar sensor having a semiconductor module according to one of Claims 1 to 6.

8. Motor vehicle radar system having a semiconductor module according to one of Claims 1 to 6.

9. Method for fabricating a semiconductor module (10) having integrated antenna structures (14; 16) for radar signals, having the steps of:
- providing (410) a semiconductor chip in the form of an integrated circuit (18) that comprises at least one RF oscillator (20) for generating a radar signal; and
- producing (412) a package layer (24), which borders the semiconductor chip at least laterally, of a package of the semiconductor module (10), wherein the production of the package layer (24) comprises the steps of: producing (414) a partial layer (24a) of the package layer (24), producing (416) at least one first antenna structure (14) on the partial layer (24a), and producing (418) a further partial layer (24b), which covers the first antenna structure (14), of the package layer (24);
wherein the method additionally comprises the steps of:
- producing (424) at least one second antenna structure (16), which is integrated in the semiconductor module (10); and
- producing (422) a redistribution layer (26) at least on a surface of the package layer (24), and wherein the step of producing (416) at least one first antenna structure (14) involves the at least one first antenna structure (14) being produced outside a height area of the redistribution layer (26),
wherein the at least one first antenna structure (14) is produced at a different height level from the at least one second antenna structure (16),
wherein the at least two antenna structures (14; 16) are stacked antenna structures, and
wherein the at least one first antenna structure (14) is embedded in said package material of the semiconductor module (10) inside a height area of a semiconductor chip forming the integrated circuit (18) in a manner laterally offset from said semiconductor chip.

## Revendications

1. Module à semiconducteur, comprenant :
- un circuit intégré (18), qui comporte au moins un oscillateur HF (20) destiné à générer un signal radar ;
- une couche de recâblage (26) servant au raccordement externe du circuit intégré (18) ; et
- au moins deux structures d'antenne (14 ; 16) intégrées dans le module à semiconducteur (10), destinées à émettre et/ou à recevoir des signaux radar, au moins l'une parmi les au moins deux structures d'antenne (14 ; 16) étant reliée au circuit intégré (18), et
au moins une première des structures d'antenne (14) étant disposée à une hauteur différente d'au moins une deuxième des structures d'antenne (16),
les au moins deux structures d'antenne (14 ; 16) étant des structures d'antenne empilées,
l'au moins une première structure d'antenne (14), à l'extérieur d'une zone de hauteur de la couche de recâblage (26), étant enrobée dans un matériau de boîtier du module à semiconducteur (10),
l'au moins une première structure d'antenne (14) étant enrobée dans ledit matériau de boîtier du module à semiconducteur (10) latéralement par rapport à une puce en semiconducteur formant le circuit intégré (18) en étant décalée au sein d'une zone de hauteur de ladite puce en semiconducteur.

2. Module à semiconducteur selon la revendication 1, avec lequel au moins une deuxième des structures d'antenne (16) est disposée dans une zone de hauteur de la couche de recâblage (26).

3. Module à semiconducteur selon l'une des revendications précédentes, le module à semiconducteur (10) possédant une unité de galette (22) et une couche d'interface (25), l'unité de galette (22) possédant une puce en semiconducteur, qui forme le circuit intégré (18), et une couche de boîtier (24), laquelle est formée par ledit matériau de boîtier du module à semiconducteur (10) et dans laquelle sont enrobées la puce en semiconducteur ainsi que l'au moins une première structure d'antenne (14), et la couche d'interface (25) possédant la couche de recâblage (26) qui relie le circuit intégré (18) à des bornes externes (28) de la couche d'interface (25).

4. Module à semiconducteur selon la revendication 3, avec lequel au moins une deuxième des structures d'antenne (16) est disposée dans la couche d'interface (25) .

5. Module à semiconducteur selon l'une des revendications précédentes, avec lequel au moins une deuxième des structures d'antenne (16) est reliée au circuit intégré (18).

6. Module à semiconducteur selon l'une des revendications précédentes, avec lequel plusieurs structures d'antenne (14) intégrées dans le module à semiconducteur sont enrobées dans ledit matériau de boîtier du module à semiconducteur (10) latéralement par rapport à une puce en semiconducteur formant le circuit intégré (18) en étant décalées au sein d'une zone de hauteur de ladite puce en semiconducteur.

7. Capteur radar comprenant un module à semiconducteur selon l'une des revendications 1 à 6.

8. Système radar de véhicule automobile comprenant un module à semiconducteur selon l'une des revendications 1 à 6.

9. Procédé de fabrication d'un module à semiconducteur (10) comprenant des structures d'antenne (14 ; 16) intégrées pour des signaux radar, comprenant les étapes suivantes :
- fourniture (410) d'une puce en semiconducteur sous la forme d'un circuit intégré (18), qui comporte au moins un oscillateur HF (20) destiné à générer un signal radar ; et
- fabrication (412) d'une couche de boîtier (24) d'un boîtier du module à semiconducteur (10) qui est adjacente au moins latéralement à la puce en semiconducteur, la fabrication de la couche de boîtier (24) comprenant les étapes suivantes : fabrication (414) d'une couche partielle (24a) de la couche de boîtier (24), fabrication (416) d'au moins une première structure d'antenne (14) sur la couche partielle (24a), et fabrication (418) d'une couche partielle (24b) supplémentaire de la couche de boîtier (24), qui recouvre la première structure d'antenne (14) ;
le procédé comprenant en outre les étapes suivantes :
- fabrication (424) d'au moins une deuxième structure d'antenne (16) intégrée dans le module à semiconducteur (10) ; et
- fabrication (422) d'une couche de recâblage (26) au moins sur une surface de la couche de boîtier (24), et dans l'étape de la fabrication (416) d'au moins une première structure d'antenne (14), l'au moins une première structure d'antenne (14) étant fabriquée à l'extérieur d'une zone de hauteur de la couche de recâblage (26),
l'au moins une première structure d'antenne (14) étant fabriquée sur un autre plan de hauteur que l'au moins une deuxième structure d'antenne (16),
les au moins deux structures d'antenne (14 ; 16) étant des structures d'antenne empilées, et
l'au moins une première structure d'antenne (14) étant enrobée dans ledit matériau de boîtier du module à semiconducteur (10) latéralement par rapport à une puce en semiconducteur formant le circuit intégré (18) en étant décalée au sein d'une zone de hauteur de ladite puce en semiconducteur.
